# EUROPÄISCHE PATENTSCHRIFT

(11) **EP 2 464 761 B1**
(45) Veröffentlichungstag und Bekanntmachung des Hinweises auf die Patenterteilung: **19.03.2014**
(21) Anmeldenummer: 10726004.4
(22) Anmeldetag: 11.05.2010
(51) Int. Cl.: C23C 16/02, C23C 16/26, C23C 16/30, C23C 28/04, C23C 30/00

(54) **KOLBENRING MIT EINER BESCHICHTUNG.**
PISTON RING WITH A COATING.
SEGMENT DE PISTON MUNI D'UN REVÊTEMENT.

(30) Priorität: 13.08.2009 DE 102009028504
(43) Veröffentlichungstag der Anmeldung: 20.06.2012
(73) Patentinhaber: Federal-Mogul Burscheid GmbH, 51399 Burscheid (DE)
(72) Erfinder: KENNEDY, Marcus, 40479 Düsseldorf (DE); ZINNABOLD, Michael, 51399 Burscheid (DE)
(74) Vertreter: HOFFMANN EITLE
(86) Internationale Anmeldenummer: PCT/EP2010/056439
(87) Internationale Veröffentlichungsnummer: WO 2011/018252

(56) Entgegenhaltungen:
- EP-A2- 1 760 172
- DE-B3-102005 063 123

## Beschreibung

### Technisches Gebiet

Die Erfindung betrifft einen Kolbenring mit einer Beschichtung auf zumindest einer Lauffläche.

Gleitelemente, wie z.B. Kolbenringe, Kolben oder Zylinderlaufbuchsen in Verbrennungsmotoren müssen über eine lange Lebensdauer sowohl bei möglichst geringer Reibung als auch mit geringem Verschleiß arbeiten. Zwar kann die Reibung, die bei Verbrennungsmotoren unmittelbar mit dem Kraftstoffverbrauch einhergeht, durch Beschichtungen aus DLC (diamond-like carbon) gering gehalten werden. Ferner können grundsätzlich Schichtdicken bis 40 µm erreicht werden. Jedoch ergibt sich bei Schichtdicken von mehr als 5 µm das Problem, dass sich die Schichteigenschaften, beispielsweise im Hinblick auf den Aufbau und die Zusammensetzung der Schicht, verändern, so dass die geforderte Lebensdauer nicht erreicht wird. Dies gilt in gleicher Weise für Schichtdicken von weniger als 5 µm.

### Stand der Technik

Bekannt sind in diesem Zusammenhang ferner PVD-Beschichtungen auf Hartstoffbasis, die zumeist Chromnitrid aufweisen.
Derartige Schichten haben zwar die erforderliche Verschleißbeständigkeit, nicht jedoch die notwendigen niedrigen Reibkoeffizienten.

Aus der DE 10 2005 063 123 B3 ist ein Gleitelement mit einer DLC-Beschichtung mit gutem Einlaufverhalten bekannt.
Insgesamt ist jedoch die Dauerhaftigkeit eines niedrigen Reibungskoeffizienten weiter verbesserungsfähig.

Die DE 10 2008 016 864 betrifft ein Gleitelement mit einer Beschichtung, die von innen nach außen eine Haftschicht, eine metallhaltige DLC-Schicht und eine metallfreie DLC-Schicht aufweist.

Aus der DE 197 35 962 A1 geht eine Führungsbuchse und ein Verfahren zur Ausbildung eines harten Kohlenstofffilms auf der Innenfläche der Führungsbuchse hervor, bei dem auf der Innenfläche ein harter Kohlenstofffilm aus hydriertem, amorphen Kohlenstoff durch ein Plasma-CVD-Verfahren ausgebildet wird.

EP1760172 A2 offenbart ein Gleitelement aus Stahl oder WC-Co mit einer Beschichtung, die von innen nach aussen eine Haftschicht aus 1 µm Chrom, eine z.B. wolframhaltige DLC-Schicht und eine metallfreie DLC-Schicht aufweist. Die Dicke der metallfreien DLC-Schicht zur Dicke der metallhaltigen DLC-Schicht weist ein Verhältnis von 0,7 bis 1,5 auf.

Schließlich zeigt die WO 2006/125683 A1 einen Kolbenring, der von innen nach außen eine Schicht mit einem Element der Gruppen IVB, VB oder VIB, eine Zwischenschicht mit einer diamantartigen Nanokomposit-Zusammensetzung und eine DLC-Schicht aufweist.

### Darstellung der Erfindung

Vor diesem Hintergrund liegt der Erfindung die Aufgabe zugrunde, einen Kolbenring zur Verfügung zu stellen, der im Hinblick auf die Kombination aus Reibungskoeffizienten und Verschleißeigenschaften weiter verbessert ist.

Die Lösung dieser Aufgabe erfolgt durch den im Anspruch 1 beschriebenen Kolbenring.

Demzufolge weist dieses auf zumindest einer Lauffläche eine Beschichtung auf, die von innen nach außen eine Haftschicht, eine metall-, insbesondere wolframhaltige DLC-Schicht und eine metallfreie DLC-Schicht aufweist, wobei das Dickenverhältnis zwischen der metallfreien und der metallhaltigen DLC-Schicht zwischen 0,7 und 1,5 und/oder das Verhältnis der Dicken zwischen der metallfreien DLC-Schicht und der Beschichtung insgesamt zwischen 0,4 und 0,6 liegt. Die Haftschicht ist bevorzugt eine Chrom-Haftschicht. Die metallhaltige DLC-Schicht weist amorphen Kohlenstoff auf und kann mit a-C:H:Me und als die bevorzugte wolframhaltige DLC-Schicht als a-C:H:W bezeichnet werden. Die äußerste oder Topschicht weist ebenfalls amorphen Kohlenstoff auf und kann mit a-C:H angegeben werden. Bei den beschriebenen Werten wurden besonders gute Eigenschaften im Hinblick auf Reibung und Verschleiß festgestellt. Diese tribologischen Eigenschaften können durch eine dickere Topschicht in Richtung einer längeren Lebensdauer beeinflusst werden. Wenn diese jedoch im Vergleich zur mittleren Schicht zu dick wird, verschlechtern sich die Verschleißwerte. Besonders gute Verschleißwerte konnten festgestellt werden, wenn die mittlere und die Topschicht eine nahezu identische Dicke aufweisen, so dass hier ein Dickenverhältnis von etwa 1,0, insbesondere 0,9 bis 1,1 bzw. ein Dickenverhältnis der Topzur Gesamtschicht von etwa 0,5, insbesondere 0,45 bis 0,55 bevorzugt wird. Im Hinblick auf die Reibung konnten für Beschichtungen innerhalb der genannten Bereiche Reibwerte festgestellt werden, welche die in einem Verbrennungsmotor gestellten Anforderungen gut erfüllen und insbesondere weitgehend konstant sind. Im Gegensatz dazu wurden außerhalb dieser Bereiche bereits nach kurzer Zeit hohe Reibwertspitzen und ein inkonstanter Reibverlauf festgestellt.

Als Erklärung für dieses Verhalten, worauf die Erfindung jedoch nicht beschränkt ist, wird derzeit angesehen, dass die metallfreie DLC-Schicht zunächst sehr hohe Eigenspannungen in das Gesamtsystem, also die Beschichtung insgesamt einbringt, die bei einer Schichtdicke der metallhaltigen DLC-Schicht, die ähnlich zu der Dicke der äußersten Schicht ist, derart ausgeglichen werden können, dass die Beschichtung hinsichtlich der Kombination zwischen Festigkeit und Zähigkeit optimal ausgebildet ist. Somit besitzt ein damit beschichteter Kolbenring, einen guten Verschleißwiderstand. Bei Schichtdickenverhältnissen zwischen der metallfreien und der metallhaltigen DLC-Schicht von < 0,7 und/oder von Top- zu Gesamtschicht von < 0,4 besitzt der Kolbenring eine zu geringe Lebensdauer, da die äußerste metallfreie DLC-Schicht zwar einen hohen Verschleißwiderstand jedoch eine zu geringe Schichtdicke aufweist. Im Gegensatz hierzu reicht bei einem Schichtdickenverhältnis zwischen der metallfreien und der metallhaltigen DLC-Schicht von > 1,5 und/oder zwischen Topzu Gesamtschicht von > 0,6 die Dicke der metallhaltigen DLC-Schicht nicht aus, um die Eigenspannungen auszugleichen. Dies führt zu einem frühzeitigen Verschleiß der DLC-Schicht insgesamt trotz der großen Dicke der äußersten Schicht oder zu einem Abplatzen der DLC-Schicht durch zu hohe Belastungen während des Betriebs.

Während die Beschichtung auf zumindest einer Lauffläche des Kolbenrings, zumindest teilweise, ausgebildet ist, kann sie sich über die gesamte Lauffläche erstrecken und insbesondere auch auf Flächen ganz oder teilweise ausgebildet sein, die an die Laufflächen angrenzen, wie z.B. die Flanken eines Kolbenrings und/oder an dem Übergang von der Lauffläche zu den daran angrenzenden Flächen.

Bevorzugte Weiterbildungen des erfindungsgemäßen Kolbenrings sind in den weiteren Ansprüchen beschrieben.

Als Grundwerkstoff des Kolbenrings, wird derzeit Gusseisen oder Stahl bevorzugt. Für diese Werkstoffe konnten besonders gute Eigenschaften festgestellt werden.

Im Hinblick auf die Härte der Schicht werden Werte von 1700 HV0.02 bis 2900 HV0.02 für die metallfreie (a-C:H-, Top-) DLC-Schicht und/oder 800 bis 1600 HV0.02 für die metallhaltige (a-C:H:Me-) DLC-Schicht bevorzugt, da bei diesen Werten eine gute Erfüllung der Anforderungen erreicht wurde.

Sowohl die metallhaltige als auch die metallfreie DLC-Schicht kann Wasserstoff enthalten, was sich bei Versuchen als günstig erwiesen hat.

Ferner wird für die wolframhaltige DLC-Schicht bevorzugt, dass sie nanokristalline Wolframcarbidausscheidungen enthält, was sich auf die Eigenschaften weiter günstig auswirkt.

Für die Dicke der Haftschicht, die insbesondere eine Chromhaftschicht ist, wird ein Wert von maximal 1 µm bevorzugt.

Um die beschriebene Balance zwischen Reibbeiwert und Verschleißeigenschaften besonders gut zu lösen, wird eine Gesamtdicke der Beschichtung von 5 µm bis 40 µm bevorzugt.

Im Hinblick auf eine effiziente Ausbildung der Beschichtung wird für die Haftschicht derzeit bevorzugt, dass sie metallisch aufgedampft ist.

Eine günstige Herstellung der erfindungsgemäßen Beschichtung wird ferner im Hinblick auf die metallhaltige und/oder metallfreie DLC-Schicht gewährleistet, wenn diese mittels eines PA-CVD-Verfahrens ausgebildet sind.

### Kurze Beschreibung der Zeichnungen

Nachfolgend werden bevorzugte Ausführungsbeispiele der Erfindung unter Bezugnahme auf die Zeichnungen näher erläutert. Es zeigen:
- Fig. 1: schematisch den Aufbau der erfindungsgemäßen Beschichtung;
- Fig. 2: eine Darstellung des relativen Verschleißes bei zwei erfindungsgemäßen Beispielen und einem Vergleichsbeispiel; und
- Fig. 3: eine Darstellung des relativen Reibungskoeffizienten bei zwei erfindungsgemäßen Beispielen und einem Vergleichsbeispiel.

### Ausführliche Beschreibung bevorzugter Ausführungsformen der Erfindung

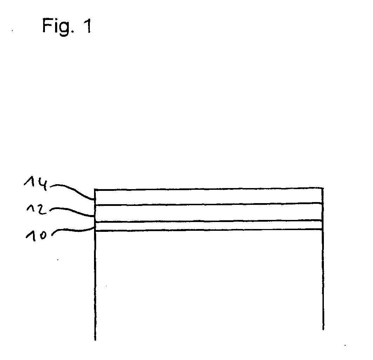

Wie in Fig. 1 schematisch dargestellt ist, weist die erfindungsgemäße Beschichtung, von innen nach außen, eine Haftschicht 10, eine Mittelschicht 12 und eine Topschicht 14 auf, deren Dicken und Dickenverhältnisse in dem oben angegebenen Bereich liegen.

### Beispiele

Anhand zweier Beispiele und eines Vergleichsbeispiels wurden die Eigenschaften der erfindungsgemäßen Beschichtung überprüft. Versuche wurden mit folgenden Beschichtungen durchgeführt:

| **Beispiel** | **1** | **2** | **3** |
|---|---|---|---|
| Verhältnis Mittelschicht/Topschicht | 0,71 | 2,40 | 1,08 |
| Anteil Topschicht an Gesamtschicht | 0,42 | 0,71 | 0,52 |

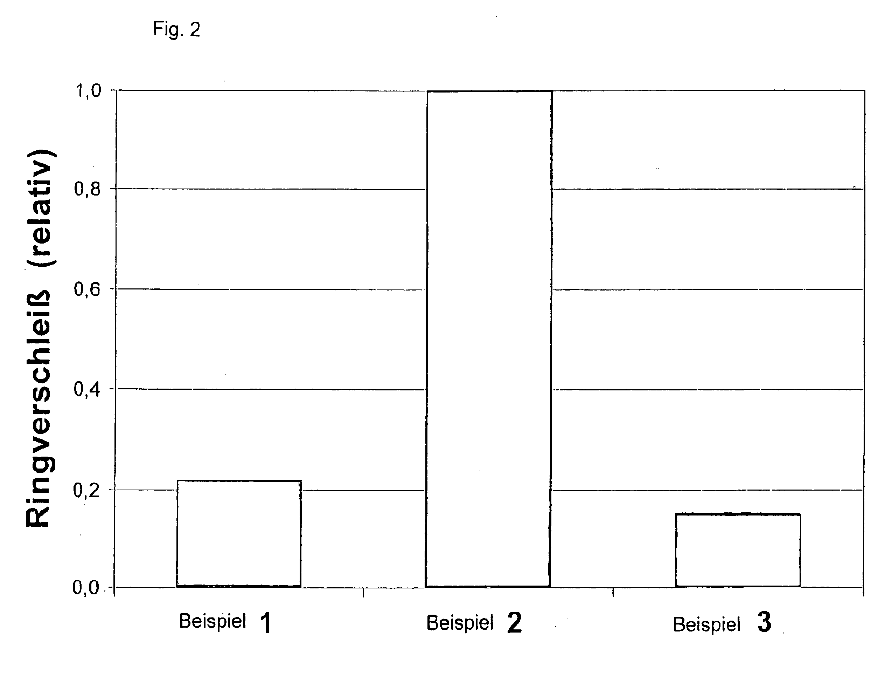

Hierbei handelt es sich bei den Beispielen 1 und 3 um erfindungsgemäße Beispiele und bei dem Beispiel 2 um ein Vergleichsbeispiel. Die Untersuchungen wurden für das System "Kolbenring/gehonte Grauguss-Zylinderlaufbuchse geschmiert" durchgeführt. In Fig. 2 sind die relativen Verschleißwerte der Kolbenringe gezeigt. Wie in Fig. 2 zu erkennen ist, weisen die erfindungsgemäßen Beispiele einen deutlich geringeren Verschleiß als das Vergleichsbeispiel 2, insbesondere etwa lediglich 20% oder weniger des bei Vergleichsbeispiel 2 auftretenden Verschleißes, auf.

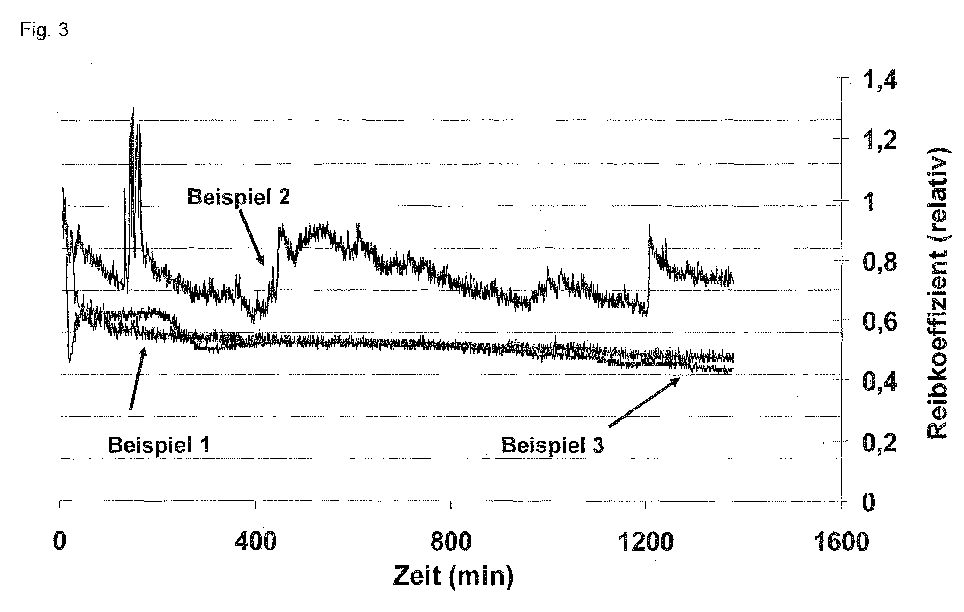

Wie Fig. 3 zeigt, ist der Reibkoeffizient bei den erfindungsgemäßen Beispielen darüber hinaus über die Zeit weitgehend konstant, während der Reibkoeffizient bei dem Vergleichsbeispiel über den gesamten Verlauf zum einen höher liegt und sehr hohe Spitzenwerte aufweist. Zum anderen schwankt der Reibkoeffizient umfangreich. Ferner kann von einem Versagen der Beschichtung gemäß diesem Vergleichsbeispiel vor Beendigung der Versuchszeit gesprochen werden.

## Patentansprüche

1. Kolbenring, mit einer Beschichtung auf zumindest einer Lauffläche, die von innen nach außen eine Haftschicht (10), eine metall-, vorzugsweise wolframhaltige DLC-Schicht (12) und eine metallfreie DLC-Schicht (14) aufweist,
**dadurch gekennzeichnet, dass**
die Dicke der metallfreien DLC-Schicht zur Dicke der metallhaltigen DLC-Schicht ein Verhältnis von 0,7 bis 1,5 und/oder zur Gesamtdicke der Beschichtung ein Verhältnis von 0,4 bis 0,6 aufweist, und die Gesamtdicke der Beschichtung 5 µm bis 40 µm beträgt.

2. Kolbenring nach Anspruch 1,
**dadurch gekennzeichnet , dass**
dieser als Grundwerkstoff Gusseisen oder Stahl aufweist.

3. Kolbenring nach Anspruch 1 oder 2,
**dadurch gekennzeichnet , dass**
die metallfreie DLC-Schicht eine Härte von 1700 HV0.02 bis 2900 HV0.02 und/oder die metallhaltige DLC-Schicht eine Härte von 800 bis 1600 HV0.02 aufweist.

4. Kolbenring nach einem der vorangehenden Ansprüche,
**dadurch gekennzeichnet , dass**
die metallhaltige und/oder die metallfreie DLC-Schicht Wasserstoff enthalten.

5. Kolbenring nach einem der vorangehenden Ansprüche,
**dadurch gekennzeichnet , dass**
die wolframhaltige DLC-Schicht nanokristalline Wolframcarbidausscheidungen enthält.

6. Kolbenring nach einem der vorangehenden Ansprüche,
**dadurch gekennzeichnet , dass**
die Haftschicht, insbesondere eine Chrom-Haftschicht, eine Dicke von maximal 1 µm aufweist.

7. Kolbenring nach einem der vorangehenden Ansprüche,
**dadurch gekennzeichnet, dass**
die Haftschicht metallisch aufgedampft ist.

8. Kolbenring nach einem der vorangehenden Ansprüche,
**dadurch gekennzeichnet , dass**
die metallhaltige und/oder die metallfreie DLC-Schicht mittels PA-CVD-Verfahren ausgebildet sind.

## Claims

1. Piston ring, having a coating on at least one bearing surface which, from the inside to the outside, has a bonding layer (10), a metal-containing, preferably tungsten-containing DLC layer (12) and a metal-free DLC layer (14), **characterised in that** the thickness of the metal-free DLC layer has a ratio of 0.7 to 1.5 to the thickness of the metal-containing DLC layer and/or a ratio of 0.4 to 0.6 to the total thickness of the coating, and the total thickness of the coating is 5 µm to 40 µm.

2. Piston ring according to claim 1, **characterised in that** it has cast iron or steel as the basic material.

3. Piston ring according to claim 1 or 2, **characterised in that** the metal-free DLC layer has a hardness of 1700 HV0.02 to 2900 HV0.02 and/or the metal-containing DLC layer has a hardness of 800 to 1600 HV0.02.

4. Piston ring according to any of the preceding claims, **characterised in that** the metal-containing and/or metal-free DLC layer contains hydrogen.

5. Piston ring according to any of the preceding claims, **characterised in that** the tungsten-containing DLC layer contains nanocrystalline tungsten carbide precipitates.

6. Piston ring according to any of the preceding claims, **characterised in that** the bonding layer, in particular a chromium bonding layer, has a thickness of not more than 1 µm.

7. Piston ring according to any of the preceding claims, **characterised in that** the bonding layer is applied by metal vapour deposition.

8. Piston ring according to any of the preceding claims, **characterised in that** the metal-containing and/or the metal-free DLC layer is formed by PA-CVD methods.

## Revendications

1. Segment de piston, comprenant un revêtement sur au moins une surface de roulement, qui présente, en allant de l'intérieur vers l'extérieur, une couche d'adhérence (10), une couche DLC contenant du métal, de préférence du tungstène (12), et une couche DLC exempte de métal (14),
**caractérisé en ce que** l'épaisseur de la couche DLC exempte de métal relativement à l'épaisseur de la couche DLC contenant du métal présente un rapport de 0,7 à 1,5 et/ou relativement à l'épaisseur totale du revêtement présente un rapport de 0,4 à 0,6, et l'épaisseur totale du revêtement est de 5 µm à 40 µm.

2. Segment de piston selon la revendication 1, **caractérisé en ce que** celui-ci comprend de la fonte ou de l'acier comme matériau de base.

3. Segment de piston selon la revendication 1 ou 2, **caractérisé en ce que** la couche DLC exempte de métal présente une dureté de 1700 HV0.02 à 2900 HV0.02 et/ou la couche DLC contenant du métal présente une dureté de 800 à 1600 HV0.02.

4. Segment de piston selon l'une des revendications précédentes, **caractérisé en ce que** la couche DLC contenant du métal et/ou la couche DLC exempte de métal contiennent de l'hydrogène.

5. Segment de piston selon l'une des revendications précédentes, **caractérisé en ce que** la couche DLC contenant du tungstène contient des précipités nanocristallins de carbure de tungstène.

6. Segment de piston selon l'une des revendications précédentes, **caractérisé en ce que** la couche d'adhérence, en particulier une couche d'adhérence chromée, présente une épaisseur de 1 µm au maximum.

7. Segment de piston selon l'une des revendications précédentes, **caractérisé en ce que** la couche d'adhérence est vaporisée par voie métallique.

8. Segment de piston selon l'une des revendications précédentes, **caractérisé en ce que** la couche DLC contenant du métal et/ou la couche DLC exempte de métal sont formées au moyen du procédé PA-CVD.
